(19) Europäisches Patentamt
European Patent Office
Office européen des brevets

(11) Numéro de publication: **0 274 298 B1**

(12) **FASCICULE DE BREVET EUROPEEN**

(45) Date de publication du fascicule du brevet: **23.05.90**

(51) Int. Cl.[5]: **C30B 15/00**, C30B 29/22, H01S 3/00

(21) Numéro de dépôt: **87402716.2**

(22) Date de dépôt: **01.12.87**

(54) **Aluminates mixtes de lanthane-magnésium, lasers utilisant des monocristaux de ces aluminates.**

(30) Priorité: **05.12.86 FR 8617082**

(43) Date de publication de la demande: **13.07.88 Bulletin 88/28**

(45) Mention de la délivrance du brevet: **23.05.90 Bulletin 90/21**

(84) Etats contractants désignés: **DE GB NL**

(56) Documents cités: **EP-A- 0 043 776**

(73) Titulaire: **COMMISSARIAT A L'ENERGIE ATOMIQUE, 31/33, rue de la Fédération, F-75015 Paris(FR)**
Titulaire: **CENTRE NATIONAL DE LA RECHERCHE SCIENTIFIQUE (CNRS), 15, Quai Anatole France, F-75007 Paris(FR)**

(72) Inventeur: **Calvat, Claude, 8, Avenue de l'Europe, F-38120 Saint Egreve(FR)**
Inventeur: **Colle, Laurent, 130, Boulevard Murat, F-75016 Paris(FR)**
Inventeur: **Couchaud, Maurice, 12, rue Pacalaire, F-38170 Seyssinet-Pariset(FR)**
Inventeur: **Lejus, Anne-Marie, 70, Avenue Aristide Briand, F-92120 Montrouge(FR)**
Inventeur: **Moncorge, Richard, 54, Grande Rue, F-01600 Trevoux(FR)**
Inventeur: **Vivien, Daniel, 6 Bis. rue de Kronstadt, F-92380 Garches(FR)**
Inventeur: **Wyon, Christophe, 5, rue du Drac, F-38120 Saint Egreve(FR)**

(74) Mandataire: **Mongrédien, André et al, c/o BREVATOME 25, rue de Ponthieu, F-75008 Paris(FR)**

EP 0 274 298 B1

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention a pour objet des aluminates mixtes de lanthane-magnésium ayant la structure de la magnétoplombite et obtenus en particulier sous forme de monocristaux.

Elle trouve une application notamment dans le domaine des micro-lasers accordables dans le proche infrarouge entre 1380 et 1800nm, utilisables pour l'optique intégrée, les télécommunications par fibres optiques, la médecine (microchirurgie, traitement de la peau), et pour l'étude des semi-conducteurs ainsi que dans le domaine des lasers accordables de puissance émettant dans le visible et le très proche infrarouge, en particulier entre 600 et 1000nm pour l'analyse à distance de la stratosphère, les communications spatiales, l'observation de la croûte terrestre, etc.

En outre, ces lasers peuvent aussi être utilisés pour effectuer des traitements de matériaux (soudure, perçage, marquage, traitement de surface), des réactions photochimiques, la fusion thermonucléaire contrôlée ou la polarisation des atomes d'un gaz tel que l'hélium.

Comme oxydes mixtes d'aluminium, on connaît en particulier des aluminates mixtes de lanthane-néodyme-magnésium du type magnétoplombite, appelés LNA, de formule chimique $La_{1-x}Nd_xMgAl_{11}O_{19}$ avec $0<x\leq1$ et en particulier de formule $La_{0,9}Nd_{0,1}MgAl_{11}O_{19}$. Ces aluminates mixtes ont notamment fait l'objet des brevets FR-A-2 448 134 et EP-A-0 043 776 déposés au nom de l'un des demandeurs.

Ces aluminates mixtes obtenus sous forme monocristalline sont particulièrement bien adaptés comme émetteurs lasers émettant dans l'infrarouge ; ils présentent des propriétés optiques comparables à celles que possède le grenat d'yttrium et d'aluminium, dans lequel 1% des ions d'yttrium est remplacé par des ions néodyme, connu sous l'abréviation YAG:$Nd^{3+}$, et que possède également l'ultraphosphate de néodyme ($NdP_5O_{14}$).

En particulier, le LNA présente des longueurs d'ondes d'émission laser très intéressantes à 1054 et 1082nm encadrant celle du YAG à 1064nm ; en outre, il présente un autre domaine de longueur d'onde d'émission autour de 1320nm, domaine correspondant à la plus faible atténuation par les fibres optiques en silice, permettant ainsi la transmision par fibres optiques d'un maximum d'informations avec un minimum de perte.

Toutefois, la fabrication de ces aluminates sous forme de monocristaux et en particulier par la méthode de Czochralski la plus couramment utilisée, conduit à des cristaux de qualité insuffisante (bulles, défauts) dès qu'il s'agit d'atteindre les grandes dimensions requises par l'industrie des lasers et plus spécialement des lasers de puissance (barreau de 6,35mm de diamètre et de 100mm de long).

Les longueurs d'onde d'émission laser du LNA sont en nombre réduit et ne jouissent que d'une faible accordabilité (quelques nanomètres).

Comme autre oxyde d'aluminium connu, on peut citer l'alumine dopée au titane, notée $Al_2O_3$:$Ti^{+3}$. Ce matériau émettant dans le visible et le très proche infrarouge et notamment entre 650 et 1000nm est généralement utilisé dans les lasers de puissance accordables.

L'alumine-titane présente un certain nombre d'inconvénients dus principalement à la faible solubilité de l'oxyde de titane ($Ti_2O_3$) dans l'alumine. Il en résulte des problèmes de perfection cristalline, une ségrégation importante lors du tirage des monocristaux, ceux-ci ne possédant pas la même composition que le bain fondu. En outre, il existe un fort gradient de la concentration en titane ; la concentration en titane est par exemple beaucoup plus faible au centre du monocristal qu'à sa périphérie, en particulier lorsqu'il est obtenu à partir de la méthode de Verneuil. Il y a enfin risque de formation de microprécipités de $TiO_2$ durant l'élaboration des monocristaux.

La faible solubilité du titane dans l'alumine n'autorise que 0,1% en poids de titane dans l'alumine, ce qui limite la puissance émettrice du matériau.

Par ailleurs, la fabrication de l'alumine titane sous forme monocristalline par la méthode de Czochralski en creuset d'iridium entraîne une usure rapide des creusets, et donc un renouvellement fréquent de ces creusets augmentant le prix de revient des monocristaux, compte tenu de la température de fusion élevée de l'alumine, voisine de 2050°C. En outre, cette température de fusion élevée entraîne une consommation d'énergie importante pour la réalisation du bain de tirage.

Comme autre matériau laser connu utilisable dans les lasers accordables entre 700 et 850nm, on peut citer le trifluorure de zinc et de potassium ($KZnF_3$) dopé avec des ions $Cr^{3+}$.

Ce matériau laser à base de fluorure présente un certain nombre d'inconvénients dus à sa fragilité chimique (mauvaise résistance aux agents chimiques et en particulier à l'eau), dus à sa fragilité physique et à sa faible dureté, ce qui le rend difficile à tailler et à polir. Or, la taille et le polissage sont nécessaires pour permettre un bon effet laser.

Comme autre matériau laser connu, utilisable dans les lasers accordables, on peut citer l'alexandrite dopée au chrome de formule $BeAl_2O_4$:$Cr^{3+}$ et le grenat de scandium et de gadolinium GSGG ($Gd_3Sc_2Ga_3O_{12}$) dopé au $Cr^{3+}$. Ces matériaux qui actuellement sont les seuls à présenter une réelle importance industrielle pour les lasers vibroniques émettent entre 650 et 900nm.

Les lasers vibroniques sont des lasers accordables continûment dans lesquels les transitions optiques responsables de l'effet laser aboutissent à des niveaux vibrationnels excités de l'état électronique fondamental.

Dans ces lasers, l'effet laser accordable provient de la forte interaction existant entre les états électroniques de certains ions luminescents, tels que les ions de transition du groupe du fer (configuration électronique $3d^n$), avec les vibrations (les phonons) du réseau cristallin. Les spectres optiques prennent en effet la forme de bandes larges et ce sont ces bandes larges qu'on observe en fluorescence qui permettent de réaliser l'accordabilité laser en continu dans un large domaine de longueurs d'onde.

Pour de plus amples détails sur les lasers accordables mettant en jeu les interactions électrons-phonons (ou lasers vibroniques), on peut se référer à la publication "Tunable Solid State Lasers" de P. Hammerlin, A. B. Budgar, A. Pinto, Ed. Stringer Verlag, pub. 1985.

Le grand intérêt de ces lasers solides à ions de transition 3d est leur grande stabilité chimique. Ils sont donc appelés à remplacer les lasers à colorant. Les matériaux lasers vibroniques à base de $Cr^{3+}$ présentent toutefois des inconvénients dus à l'absorption du rayonnement de pompage optique ou du rayonnement laser de l'ion activateur dans l'un des états excités du chrome, entraînant des pertes d'énergie lumineuse plutôt gênante pour la réalisation de lasers de puissance.

L'invention a justement pour objet de nouveaux aluminates mixtes de lanthane-magnésium utilisables comme émetteurs lasers permettant notamment de remédier aux différents inconvénients donnés ci-dessus.

En particulier, ces nouveaux aluminates peuvent être réalisés sous forme de monocristaux de grandes dimensions, et par conséquent être utilisés dans l'industrie des lasers de puissance émettant dans une gamme de longueur d'onde allant du visible au très proche infrarouge. Ils présentent de bonnes qualités cristallines.

En outre, ces nouveaux aluminates présentent une température de fusion (de l'ordre de 1870°C) inférieure à celle de l'alumine, ce qui entraîne une diminution, au moins de moitié, de la consommation des creusets en iridium lors du tirage par la méthode de Czochralski. Par ailleurs, ils ne posent aucun problème quant à leur taille et à leur polissage.

De façon plus précise, l'invention a pour objet des aluminates de lanthane-magnésium du type magnétoplombite dans lesquels une partie de l'aluminium est substituée par un métal de transition tel que le titane ou le zirconium ou dans lesquels une partie du magnésium est substituée par un métal de transition tel que le vanadium. Dans les deux cas, le métal de transition constitue l'activateur laser du matériau.

Les aluminates selon l'invention comportent une matrice cristalline du type $LaMgAl_{11}O_{19}$. Cette matrice présente une température de fusion (1870°c) inférieure à celle de l'alumine. En outre, elle présente l'avantage de pouvoir accepter aussi bien des ions métalliques divalents que trivalents, en substitution d'une partie des ions $Al^{3+}$ ou $Mg^{2+}$, sans introduire de compensation de charge, ce qui simplifie la cristallogénèse de ces matériaux.

Cette matrice présente encore l'avantage d'être riche en sites octaédriques, accessibles aux cations métalliques, qui sont les seuls sites intéressants pour les lasers accordables. Par ailleurs, elle présente une structure cristalline à maille hexagonale et des propriétés mécaniques voisines de celles de l'alumine.

Les aluminates mixtes de l'invention présentent, en outre, pendant la croissance du monocristal, une absence de ségrégation des constituants permettant d'augmenter la vitesse de tirage du monocristal par rapport à celle de certains matériaux de l'art antérieur. Ceci entraîne de ce fait un gain important sur la durée de préparation des monocristaux ainsi que sur la durée de vie des creusets contenant le bain fondu.

Selon une première caractéristique de l'invention, les aluminates mixtes de lanthane-magnésium présentent la formule (I) suivante :

$$La_{1-x}Mg_{1-y-z-t}V_{t+u}Al_{11+x+2y/3-u}O_{19-z} \quad (I)$$

dans laquelle x représente un nombre tel que $0<x<0,3$ ; y, z, t et u représentent des nombres tels que $0<y+z+t\leq 1$ et $0<t+u\leq 1$, avec $0\leq y<1$, $0\leq z<1$, $0<t\leq 1$ et $0\leq u<1$ ; et ces aluminates sont monophasés et présentent la structure de la magnétoplombite.

Dans ces aluminates mixtes de lanthane-magnésium, l'activateur laser est l'ion $V^{2+}$ en symétrie octaédrique. Toutefois, lors de la fabrication de cet aluminate, un certain nombre d'ions $V^{3+}$ peut être formé, d'où la présence de l'indice u dans la formule. Ces ions $V^{3+}$ sont considérés comme des impuretés. Aussi, de façon avantageuse, u est égal à 0.

Selon l'invention, les aluminates de lanthane-magnésium dopés au vanadium, notés ci-après LMA:$V^{2+}$, peuvent être utilisés comme émetteurs lasers dans des lasers accordables continûment entre 1380 et 1800nm. Ces lasers peuvent être en particulier des lasers de puissance fonctionnant en continu.

De préférence, la concentration en ions $V^{2+}$ dans l'aluminate de formule (I) est telle que $0,02\leq t\leq 0,2$.

De façon avantageuse, y, z et t dans la formule (I) sont tels que $0,3\leq y+z+t\leq 0,6$. De préférence, z est choisi égal à 0, ce qui correspond à un nombre minimum de lacunes d'oxygène dans le réseau cristallin.

Selon une autre caractéristique principale de l'invention, les aluminates mixtes de lanthane-magnésium présentent la formule (II) suivante :

$$La_{1-x}Mg_{1-y-z}M_tV_vAl_{11+x+2y/3-v}O_{19-z} \quad (II)$$

dans laquelle Mt représente un métal de transition choisi parmi le titane et le zirconium ; x représente un nombre tel que $0<x<0,3$ ; y et z représentent des nombres tels que $0\leq y+z\leq 1$ avec $0\leq y\leq 1$ et $0\leq z\leq 1$ ; et v représente un nombre tel que $0<v\leq 1$ ; et ces aluminates sont monophasés et présentent la structure de la magnétoplombite.

La matrice du type $LaMgAl_{11}O_{19}$ selon l'invention présente par rapport à l'alumine une plus grande aptitude à dissoudre le titane, évitant ainsi une ségrégation et un gradient de la concentration du titane dans la matrice.

Les aluminates de lanthane-magnésium dopé au titane seront notés ci-après LMA:$Ti^{3+}$.

L'utilisation du titane comme métal de transition permet la réalisation de monocristaux utilisables pour la fabrication de lasers accordables continûment entre 650 et 1000nm.

L'effet laser est dû à l'ion $Ti^{3+}$. Cet ion est particulièrement intéressant pour la fabrication de lasers de forte puissance car il ne présente pas, contrairement à la plupart des autres ions de transition utilisables comme activateur laser et en particulier au chrome, de phénomènes d'absorption dans l'état excité diminuant le rendement laser, c'est-à-dire le rapport de l'énergie lumineuse fournie par rapport à l'énergie lumineuse excitatrice. Ceci tient au fait que l'ion $Ti^{3+}$ ne présente que deux niveaux d'énergie en symétrie octaédrique.

En outre, la présence de l'ion $Ti^{3+}$ dans la matrice permet l'accordabilité du laser sur une large plage.

Dans le cas de la substitution d'une partie de l'aluminium par le zirconium, élément 4d de la même famille que le titane, l'effet laser est dû à l'ion $Zr^{3+}$. Les aluminates mixtes à base de zirconium, notés ci-après LMA:$Zr^{3+}$, peuvent être utilisés comme émetteurs lasers dans une plage d'accordabilité continue en longueur d'onde déplacée légèrement vers le visible par rapport à celle des ions $Ti^{3+}$.

De façon avantageuse, la quantité d'ions $Zr^{3+}$ ou $Ti^{3+}$ dans l'aluminate de formule (II) est telle que $0,004\leq v\leq 0,2$.

De préférence, y et z dans la formule (II) sont choisis tels que $0,3\leq y+z\leq 0,6$. En particulier, z est choisi égal à 0, ce qui correspond à un nombre minimum de lacunes d'oxygène dans le réseau cristallin.

De façon avantageuse la quantité de lanthane dans les aluminates de formule (I) ou (II) selon l'invention est telle que $0,05\leq x<0,2$.

L'effet laser peut être obtenu, avec des monocristaux d'un aluminate répondant à la formule (I) ou (II), en utilisant un pompage optique, en particulier un pompage par lampe ou par un autre laser, permettant ainsi la réalisation de lasers de puissance.

D'autres caractéristiques et avantages de l'invention ressortiront mieux de la description qui va suivre, donnée à titre illustratif et nullement limitatif, en référence aux figures annexées, dans lesquelles :

- la figure 1 représente la courbe d'absorption ainsi que la courbe d'émission lumineuse d'un aluminate selon l'invention dont l'activateur laser est l'ion $V^{2+}$,
- la figure 2 montre la courbe d'absorption et la courbe de fluorescence d'un aluminate selon l'invention dont l'activateur laser est l'ion $Ti^{3+}$,
- la figure 3 représente schématiquement un laser continu utilisant un monocristal d'aluminate selon l'invention, et
- la figure 4 représente schématiquement un laser pulsé de puissance utilisant un monocristal d'aluminate selon l'invention.

On décrit ci-après la fabrication des aluminates mixtes de lanthane-magnésium selon l'invention répondant à la formule (I).

Ces aluminates sont obtenus en mélangeant intimement dans des proportions requises, des poudres du commerce de haute pureté des oxydes de lanthane ($La_2O_3$), de magnésium ($MgO$), d'aluminium ($Al_2O_3$) et d'un oxyde de vanadium tel que $V_2O_5$ ou $VO_2$, puis en calcinant le mélange obtenu à une température de 1500°C. Après broyage du produit résultant, on obtient une poudre qui peut alors être traitée en vue de réaliser un monocristal.

Cette poudre d'aluminate peut aussi être obtenue par co-précipitation des hydroxydes de lanthane, de magnésium, d'aluminium et de vanadium. Cette co-précipitation est réalisée avec de l'ammoniac dans une solution aqueuse ou non telle que l'alcool absolu contenant un mélange de nitrates ou chlorures des différents éléments métalliques de l'aluminate.

Les nitrates ou chlorures de magnésium et d'aluminium sont ceux du commerce tandis que les autres nitrates ou chlorures sont obtenus par dissolution de l'oxyde correspondant respectivement dans l'acide nitrique ou chlorhydrique.

Le mélange obtenu est ensuite traité à 400°C en atmosphère ventilée jusqu'à déshydratation et élimination complète du nitrate ou chlorure d'ammonium puis calciné à une température de 1500°C. La poudre obtenue après broyage peut alors être traitée en vue de réaliser un monocristal.

Les oxydes pulvérulents des différents éléments utilisés présentent une granulométrie allant de 1 à 10 µm et une pureté supérieure à 99,99% afin d'obtenir un rendement aussi élevé que possible pour l'émission laser.

Selon le degré d'oxydation du vanadium dans l'oxyde de départ, on peut être amené à faire suivre le traitement thermique ci-dessus d'un second traitement thermique en atmosphère réductrice, hydrogène par exemple, de façon à ce que le vanadium passe de l'état pentavalent ou tétravalent à l'état divalent.

Le vanadium n'est jamais introduit sous forme $V^{3+}$ dans le bain fondu.

De préférence, les monocristaux des aluminates selon l'invention sont élaborés par tirage Czochralski. Toutefois, toute autre méthode de cristallogénèse utilisant un bain fondu peut être utilisée comme par exemple la méthode de zone flottante, la méthode de Bridgman, la méthode de Verneuil, la méthode de Kyropoulos ou de l'auto-creuset, etc.

A titre d'exemple, on décrit ci-après l'obtention d'un monocristal par tirage Czochralski.

La poudre d'aluminate mixte obtenue précédemment, par co-précipitation ou mélange intime d'oxyde puis traitement thermique, est placée dans un creuset en iridium puis portée à sa température de fusion, égale à 1870°C, à l'abri de l'oxygène de l'air, de manière à former un bain fondu.

Un germe monocristallin de même composition que le bain fondu et taillé parallèlement soit à la direction cristallographique dite c, soit à la direction dite a de la maille hexagonale du composé, est alors amené au contact du bain liquide puis remonté lentement vers le haut tout en étant animé d'un mouvement de rotation sur lui-même. Le monocristal est ainsi formé progressivement au bout du germe selon la direction imposée par celui-ci.

Le monocristal une fois produit, peut être recuit à une température supérieure ou égale à 1000°C dans une atmosphère réductrice, hydrogène par exemple afin de réduire les ions vanadium pentavalents, tétravalents ou trivalents éventuellement présents dans le cristal, en ions vanadium divalents seuls inducteurs de l'émission stimulée accordables continûment entre 1380 et 1800nm.

Ce procédé a permis en particulier la fabrication des monocristaux d'aluminates de lanthane-magnésium dopés au vanadium donnés dans le tableau I ci-après.

Dans la partie supérieure du tableau I, on trouve la masse des constituants du bain, exprimée en grammes.

Dans la partie gauche inférieure du tableau I, on trouve la composition du cristal obtenu, donnée sous forme de x,y, z, t et u et dans la partie droite inférieure, la formule du monocristal obtenu.

Dans ce tableau I, ne figurent pas les indices z et u puisqu'ils sont égaux à zéro.

Dans ce tableau I, les composés n°2 et n°3 présentent une fusion dite congruente, pour laquelle la composition du bain est très proche de celle du cristal obtenu.

Pour obtenir des monocristaux d'aluminates de lanthane-magnésium dopés au titane, on opère comme précédemment en remplaçant l'oxyde de vanadium par l'oxyde de titane $Ti_2O_3$. En outre, du fait que le titane est introduit dans le bain à l'état trivalent, il n'est pas nécessaire de faire suivre l'étape de recuit à 1500°C par un nouveau recuit en atmosphère réductrice. En revanche, le recuit à 1000°C en présence d'hydrogène du monocristal formé est maintenu.

Il est aussi possible de former des aluminates dopés au titane en partant de l'oxyde $TiO_2$. Dans ce cas, l'étape de recuit sous agent réducteur après la calcination à 1500°C peut être effectuée afin de faire passer le titane de l'état d'oxydation IV à l'état d'oxydation III seul responsable de l'effet laser.

Les monocristaux d'aluminates de lanthane-magnésium dopé au titane présentent une émission stimulée accordable continûment entre 650 et 1000nm.

Dans le tableau II ci-après, on donne des exemples de fabrication de monocristaux d'aluminates dopés au titane. Le tableau II est similaire au tableau I à l'exception de l'apparition de l'indice v à la place de l'indice t.

Dans ce tableau, les composés 5 à 8 présentent une fusion proche de la congruence.

L'obtention d'un monocristal d'un aluminate de lanthane-magnésium dopé au zirconium peut être préparée comme précédemment en remplaçant l'oxyde de vanadium par $ZrO_2$. Ici encore, l'étape de réduction après calcination à 1500°C est nécessaire pour faire passer le zirconium de l'état d'oxydation IV à l'état d'oxydation III seul responsable de l'effet laser.

Dans le tableau III ci-après, on donne des exemples de fabrication de monocristaux d'aluminates selon l'invention contenant comme activateurs lasers du zirconium. Ce tableau III est similaire au tableau II. Le composé 11 présente une fusion proche de la congruence.

Bien que l'indice z de la composition des cristaux n'apparaisse pas dans les tableaux I - III, cette valeur est certainement légèrement différente de 0 mais l'analyse X au microscope à balayage n'a pas permis de détecter d'écart significatif de z à la valeur zéro.

Sur la figure 1, on a représenté le spectre d'absorption et le spectre d'émission de l'ion $V^{2+}$ dans un aluminate de formule $La_{0,9}Mg_{0,45}V_{0,02}Al_{11,453}O_{19}$.

La courbe A donne la densité optique (D.O) exprimée en unités arbitraires (u.ab) en fonction de la longueur d'onde ($\lambda$), exprimée en nanomètres, et la courbe B donne l'intensité de fluorescence (If) exprimée en unités arbitraires en fonction de la longueur d'onde ($\lambda$).

L'excitation de l'aluminate peut être réalisée à l'une ou l'autre des deux longueurs d'onde 532nm , 1064nm d'un laser excitateur à YAG:$Nd^{3+}$.

Les aluminates au vanadium selon l'invention, notés LMA:$V^{2+}$, présentent plusieurs larges bandes d'absorption permettant ainsi une excitation aisée de l'ion $V^{2+}$.

La détection de la fluorescence a été effectuée avec un détecteur au germanium refroidi à l'azote présentant sa longueur d'onde de coupure vers 1700nm, ce qui n'a pas permis d'obtenir le spectre complet d'émission du LMA:$V^{2+}$. Il semblerait a priori que la bande d'émission laser de cet aluminate soit comprise entre 1380 et 1800nm. Cette large bande d'émission permet l'utilisation du LMA:$V^{2+}$ dans un laser accor-

dable continûment.

Sur la figure 2, on a représenté les spectres d'absorption et d'émission de l'ion $Ti^{3+}$ dans un aluminate selon l'invention, de formule $La_{0,9}Mg_{0,5}Al_{11,319}Ti_{0,114}O_{19}$, noté LMA:$Ti^{3+}$.

La courbe C correspond à l'absorption et donne la densité optique (D.O), exprimée en unités arbitraires, en fonction de la longueur d'onde ($\lambda$) exprimée en nanomètres, et la courbe D correspondant à l'émission donne l'intensité de fluorescence (If), exprimée en unités arbitraires en fontion de la longueur d'onde ($\lambda$).

Le LMA:$Ti^{3+}$ a été excité à l'une ou l'autre des longueurs d'onde suivantes : 514,5nm provenant d'un laser à argon, 532nm provenant d'un laser à YAG:$Nd^{3+}$. Cet aluminate présente aussi l'avantage d'une grande bande d'absorption facilitant ainsi l'excitation $Ti^{3+}$.

La courbe d'émission a été tracée à l'aide d'un photomultiplicateur présentant une longueur d'onde de coupure vers 800nm, ce qui n'a pas permis de tracer la courbe complète d'émission. Toutefois, on peut estimer que la bande d'émission du $Ti^{3+}$ s'étend de 650 à 1000nm. Cette grande bande d'émission permet l'utilisation du LMA:$Ti^{3+}$ dans un laser accordable continûment.

Sur la figure 3, on a représenté schématiquement un laser de puissance, accordable et continu, utilisant un monocristal d'aluminate selon l'invention.

Ce laser comprend une cavité laser 2 contenant un barreau 4 d'aluminate selon l'invention disposé perpendiculairement à l'axe longitudinal 3 du laser. Pour une émission laser entre 650 et 1000nm, le barreau 4 peut être formé de l'aluminate de l'exemple 7 ou 8.

Une source de lumière monochromatique 6, telle qu'un laser à YAG:$Nd^{3+}$ doublé en fréquence permet d'irradier le barreau 4, via une lentille de convergence 7, afin d'assurer le pompage optique du barreau 4.

La cavité laser 2 se compose aussi d'une lentille convergente 8, transformant la lumière émise par le barreau d'aluminate 4 en un faisceau de lumière parallèle, qui est envoyé sur un miroir de sortie 10.

Après réflexion sur ce miroir 10, le faiceau lumineux traverse à nouveau la lentille convergente 8 puis le milieu amplificateur ou barreau 4. Le faisceau laser amplifié est alors réfléchi par un miroir d'entrée dichroïque 12, qui est transparent à la lumière émise par la source monochromatique 6 et opaque à celle émise par le monocristal d'aluminate 4.

Une faible partie du rayonnement arrivant sur le miroir 10 est transmise par celui-ci et constitue l'émission laser hors de la cavité 2, le miroir 10 étant partiellement transparent à la lumière émise par le monocristal 4.

L'accordabilité en longueur d'onde peut être obtenue à l'aide d'un système de sélection en longueur d'onde 14, intercalé entre la lentille convergente 8 et le miroir de sortie 10. Ce système est par exemple un prisme à angle de Brewster ou un filtre biréfringent.

Pour obtenir une émission laser légèrement déplacée dans le visible par rapport à l'émission de l'ion $Ti^{3+}$ (par exemple une émission entre 600 et 900nm), on peut remplacer le barreau 4 à base de $Ti^{3+}$ par un barreau de LMA:$Zr^{3+}$ ayant la composition définie dans l'exemple 11.

De même afin d'obtenir une émission laser entre 1380 et 1800nm, il est possible d'utiliser comme barreau 4, un barreau formé d'un composé corrrespondant à la formule de l'exemple 1 ou 2.

L'emploi d'un aluminate, dont l'ion activateur est $V^{2+}$, nécessite l'utilisation d'une cavité laser 2 travaillant sous-vide. A cet effet, on a représenté sur la figure 3, une pompe à vide de référence 18. En outre, l'émission laser ne peut être obtenue qu'à basse température et en particulier à la température de liquéfaction de l'azote, soit 77°K.

A cet effet, le barreau 4 est placé au contact d'un support froid 20 renfermant de l'azote liquide 22, le remplissage de ce support 20 étant assuré à l'aide d'un réservoir 24 d'azote liquide. Afin de ne pas occulter la lumière provenant de la source 6 et celle provenant du barreau 4, le support froid 20 se présente sous la forme d'une bague à section rectangulaire prenant contact sur toutes les faces latérales du barreau 4.

Les aluminates selon l'invention peuvent aussi être utilisés sous forme monocristalline dans un laser de puissance émettant sous forme d'impulsions. A cet effet, on a représenté sur la figure 4, un laser de puissance pulsé émettant dans le proche infrarouge.

Ce laser pulsé comprend une cavité 26 contenant un barreau monocristallin 28 d'un aluminate selon l'invention disposé parallèlement à l'axe longitudinal 27 du laser. Cet aluminate présente en particulier la formule correspondant à l'exemple 5, 6 ou 10.

De part et d'autre du barreau 28, sont diposées des lampes flash au xénon de forte intensité 30 et 32, de forme allongée, orientées aussi selon l'axe 27 du laser. Ces lampes assurent un pompage optique longitudinal du barreau d'aluminate 28.

La cavité laser 26 se compose aussi d'une lame quart d'onde 34 transformant la lumière incidente polarisée linéairement, issue du barreau 28, en une lumière polarisée circulairement. Cette lame est suivie d'un miroir plan 36 et d'un miroir convexe 38 divergent.

Après réflexion sur le miroir 38, le faisceau lumineux élargi, adapté et polarisé circulairement, traverse à nouveau la lame quart d'onde 34 produisant ainsi un faisceau polarisé verticalement qui balaye complètement le milieu amplificateur ou barreau 28, en en extrayant le maximum d'énergie lumineuse.

Le faisceau laser amplifié se propageant dans la direction d'un autre miroir 40 hautement réfléchissant concave, est interrompu par un prisme polariseur 42 éjectant le faisceau polarisé verticalement 44 hors de la cavité laser. Une lentille convergente 46 permet l'obtention d'un faisceau de lumière parallèle.

Ce laser pulsé est équipé d'un interrupteur électrooptique 48, plus généralement désigné sous le vocable anglo-saxon de "Q-Switch", disposé entre le miroir concave 40 et le polariseur de sortie 42.

Lorsque cet interrupteur est fermé, c'est-à-dire qu'une tension lui est appliquée, le laser ne peut fonctionner. En effet, pendant que l'on "pompe" le milieu amplificateur 28 avec les lampes 30 et 32, le polariseur 42 est transparent aux photons polarisés horizontalement et laisse passer la lumière vers l'interrupteur 48. Celui-ci faisant tourner la direction de polarisation de 90°, empêche le polariseur 42 de transmettre cette lumière.

Inversement, lorsqu'on ouvre l'interrupteur électrooptique 48, celui-ci n'altère plus la polarisation horizontale issue du polariseur 42 permettant ainsi à la cavité laser 26 d'amplifier la lumière émise par le barreau 28.

Un diaphragme 50 peut être intercalé entre l'interrupteur et le polariseur pour canaliser la lumière laser.

L'accordabilité en longueur d'onde est réalisée avec un dispositif de sélection en longueur d'onde 52, tel que décrit ci-dessus, intercalé entre la lame 34 et le miroir 36.

Les lasers décrits ci-dessus n'ont bien entendu été donnés qu'à titre illustratif, d'autres types de lasers pouvant être équipés d'un monocristal d'un aluminate selon l'invention répondant aux formules (I) et (II).

Les monocristaux des aluminates selon l'invention peuvent en particulier être utilisés dans des lasers destinés à la découpe ou au marquage de matériaux ainsi que pour réaliser des soudures.

La découpe d'un matériau est assurée par exemple en plaçant un aluminate monocristallin selon l'invention dans la cavité d'un laser, tel que décrit précédemment, en orientant puis en focalisant à la surface du matériau la lumière issue du laser afin de porter ce matériau localement à son point de fusion et d'assurer ainsi sa découpe, au fur et à mesure qu'il se déplace dans le faisceau laser.

Les aluminates selon l'invention peuvent aussi être utilisés pour des lasers destinés à la détection de gaz et d'aérosols dans l'atmosphère terrestre.

A cet effet, on place un barreau monocristallin d'un aluminate selon l'invention dans une cavité laser telle que décrite précédemment. A l'aide du sélecteur en longueur d'onde, on détermine la longueur d'onde laser correspondant à une bande d'absorption de la substance à détecter. L'affaiblissement de l'écho laser envoyé par un obstacle présent dans l'atmosphère est fonction de la quantité et de la nature de l'espèce chimique présente entre le laser et cet obstacle. Ceci permet de déterminer la quantité de gaz et d'aérosols présente dans l'atmosphère terrestre, ce qui peut être intéressant dans le domaine de la météorologie à distance.

## TABLEAU I

Fabrication de composés de formule

$$La_{1-x}Mg_{1-y-t}V_tAl_{11+x+2y/3}O_{19}$$

| Exemple | Masse des constituants du bain (g) | | | | |
|---|---|---|---|---|---|
| | $La_2O_3$ | MgO | $Al_2O_3$ | $V_2O_5$ | $VO_2$ |
| 1 | 76,404 | 24,308 | 385,973 | 6,093 | |
| 2 | 98.234 | 12.154 | 390,516 | 3,047 | |
| 3 | 99,325 | 11,344 | 388,364 | | 2,779 |
| 4 | 109,149 | 8,103 | 375,726 | | 11,114 |

| Exemple | Composition du cristal obtenu | | | Formule du cristal obtenu |
|---|---|---|---|---|
| | x | y | t | |
| 1 | 0,18 | 0,32 | 0,05 | $La_{0,82}Mg_{0,63}V_{0,05}Al_{11,393}O_{19}$ |
| 2 | 0,11 | 0,49 | 0,02 | $La_{0,89}Mg_{0,49}V_{0,02}Al_{11,436}O_{19}$ |
| 3 | 0,10 | 0,53 | 0,02 | $La_{0,90}Mg_{0,45}V_{0,02}Al_{11,453}O_{19}$ |
| 4 | 0,08 | 0,43 | 0,12 | $La_{0,92}Mg_{0,43}V_{0,12}Al_{11,366}O_{19}$ |

## TABLEAU II

Fabrication de composés de formule $La_{1-x}Mg_{1-y}Ti_{v}\ Al_{11+x+2y/3}O_{19}$

| Exemple | Masse des constituants du bain (g) | | | | |
|---|---|---|---|---|---|
| | $La_2O_3$ | MgO | $Al_2O_3$ | $Ti_2O_3$ | $TiO_2$ |
| 5 | 98,234 | 13,504 | 389,973 | 0,621 | |
| 6 | 98,234 | 13,504 | 374,838 | 1,252 | |
| 7 | 99,325 | 13,774 | 382,114 | 11,079 | |
| 8 | 99,325 | 13,774 | 384,163 | | 9,208 |
| 9 | 76,404 | 18,906 | 382,558 | | 5,353 |

| Exemple | Composition du cristal obtenu | | | Formule du cristal obtenu |
|---|---|---|---|---|
| | x | y | v | |
| 5 | 0,11 | 0,49 | 0,06 | $La_{0,89}\ Mg_{0,51}\ Ti_{0,06}\ Al_{11,436}\ O_{19}$ |
| 6 | 0,11 | 0,54 | 0,12 | $La_{0,89}\ Mg_{0,46}\ Ti_{0,12}\ Al_{11,470}\ O_{19}$ |
| 7 | 0,10 | 0,50 | 0,114 | $La_{0,90}\ Mg_{0,50}\ Ti_{0,114}\ Al_{11,319}\ O_{19}$ |
| 8 | 0,10 | 0,50 | 0,086 | $La_{0,90}\ Mg_{0,50}\ Ti_{0,086}\ Al_{11,347}\ O_{19}$ |
| 9 | 0,18 | 0,42 | 0,05 | $La_{0,82}\ Mg_{0,58}\ Ti_{0,05}\ Al_{11,460}\ O_{19}$ |

**TABLEAU III**

Fabrication de composés de formule

$La_{1-x}Mg_{1-y}Zr_vAl_{11+x+2y/3}O_{19}$

| Exemple | Masse des constituants du bain (g) | | | |
|---|---|---|---|---|
| | $La_2O_3$ | MgO | $Al_2O_3$ | $ZrO_2$ |
| 10 | 98,234 | 13,504 | 388,808 | 4,128 |
| 11 | 99,325 | 13,774 | 371,525 | 44,58 |

| Exemple | Composition du cristal obtenu | | | Formule du cristal obtenu |
|---|---|---|---|---|
| | x | y | v | |
| 10 | 0,11 | 0,49 | 0,008 | $La_{0,89}\ Mg_{0,51}\ Zr_{0,008}\ Al_{11,436}\ O_{19}$ |
| 11 | 0,10 | 0,50 | 0,086 | $La_{0,90}\ Mg_{0,50}\ Zr_{0,086}\ Al_{11,347}\ O_{19}$ |

**Revendications**

1. Aluminate mixte de lanthane-magnésium, caractérisé en ce que l'aluminate présente la formule (I) suivante :

$La_{1-x}Mg_{1-y-z-t}V_{t+u}Al_{11+x+2y/3-u}O_{19-z}$ (I)

2. Aluminate mixte selon la revendication 1, caractérisé en ce que x est tel que $0,05 \leq x \leq 0,2$.

3. Aluminate mixte selon la revendication 1 ou 2, caractérisé en ce que y, z et t sont tels que $0,3 \leq y+z+t \leq 0,6$.

4. Aluminate mixte selon l'une quelconque des revendications 1 à 3, caractérisé en ce que z est égal à 0.

5. Aluminate mixte selon l'une quelconque des revendications 1 à 4, caractérisé en ce que u est égal à 0.

6. Aluminate mixte selon l'une quelconque des revendications 1 à 5, caractérisé en ce que t est tel que $0{,}02 \leq t \leq 0{,}2$.

7. Aluminate mixte de lanthane-magnésium, caractérisé en ce que l'aluminate présente la formule (II) suivante :

$La_{1-x}Mg_{1-y-z}Mt_vAl_{11+x+2y/3-v}O_{19-z}$ (II)

dans laquelle Mt représente un métal de transition choisi parmi le titane et le zirconium ; x représente un nombre tel que $0<x<0{,}3$ ; y et z représentent des nombres tels que $0 \leq y+z \leq 1$ avec $0 \leq y \leq 1$ et $0 \leq z \leq 1$ ; et v représente un nombre tel que $0<v \leq 1$ ; et en ce que l'aluminate est monophasé et présente la structure de la magnétoplombite.

8. Aluminate mixte selon la revendication 7, caractérisé en ce que x est tel que $0{,}05 \leq x \leq 0{,}2$.

9. Aluminate mixte selon la revendication 7 ou 8, caractérisé en ce que y et z sont tels que $0{,}3 \leq y+z \leq 0{,}6$.

10. Aluminate mixte selon l'une quelconque des revendications 7 à 9, caractérisé en ce que z est égal à 0.

11. Aluminate mixte selon l'une quelconque des revendications 7 à 10, caractérisé en ce que v est tel que $0{,}004 \leq v \leq 0{,}2$.

12. Laser accordable entre 1380 et 1800nm, caractérisé en ce qu'il comprend un monocristal (4) d'un aluminate mixte selon l'une quelconque des revendications 1 à 6.

13. Laser accordable entre 600 et 1000nm, caractérisé en ce qu'il comprend un monocristal (4, 28) d'un aluminate mixte selon l'une quelconque des revendiations 7 à 11.

**Patentansprüche**

1. Lanthan-Magnesium-Mischaluminat, dadurch gekennzeichnet, daß das Aluminat die folgende Formel (I) hat:
$La_{1-x}Mg_{1-y-z-t}V_{t+u}Al_{11+x+2y/3-u}O_{19-z}$ (I)
worin bedeuten:
x eine solche Zahl, daß $0< x< 0{,}3$;
y, z, t und u solche Zahlen, daß $0< y+ z+ t \leq 1$ und $0< t+ u \leq 1$
mit $0 \leq y \leq 1{,}0 \leq z< 1{,}0< t \leq 1$ und $0 \leq u<1$; und
daß das Aluminat monophasisch ist und die Struktur des Magnetoplombits hat.

2. Mischaluminat nach Anspruch 1, dadurch gekennzeichnet, daß x eine solche Zahl bedeutet, daß $0{,}05 \leq x \leq 0{,}2$.

3. Mischaluminat nach Anspruch 1 oder 2, dadurch gekennzeichnet, daß y, z und t solche Zahlen bedeuten, daß $0{,}3 \leq y+ z+ t \leq 0{,}6$.

4. Mischaluminat nach einem der Ansprüche 1 bis 3, dadurch gekennzeichnet, daß z für die Zahl 0 steht.

5. Mischaluminat nach einem der Ansprüche 1 bis 4, dadurch gekennzeichnet, daß u für die Zahl 0 steht.

6. Mischaluminat nach einem der Ansprüche 1 bis 5, dadurch gekennzeichnet, daß t eine solche Zahl ist, daß $0{,}02 \leq t \leq 0{,}2$.

7. Lanthan-Magnesium-Mischaluminat, dadurch gekennzeichnet, daß das Aluminat die folgende Formel (II) hat;
$La_{1-x}Mg_{1-y-z}Mt_vAl_{11+x+2y/3-v}O_{19-z}$ (II)
worin bedeuten:
Mt ein Übergangsmetall, ausgewählt aus Titan und Zirkonium;
x eine solche Zahl, daß $0< x < 0{,}3$;
y und z solche Zahlen, daß $0 \leq y+ z \leq 1$ mit $0 \leq y \leq 1$ und $0 \leq z \leq 1$; und
v eine solche Zahl, daß $0 < v \leq 1$; und
daß das Aluminat monophasisch ist und die Struktur des Magnetoplombits hat.

8. Mischaluminat nach Anspruch 7, dadurch gekennzeichnet, daß x eine solche Zahl ist, daß $0{,}05 \leq x \leq 0{,}2$.

9. Mischaluminat nach Anspruch 7 oder 8, dadurch gekennzeichnet, daß y und z solche Zahlen sind, daß $0{,}3 \leq y+ z \leq 0{,}6$.

10. Mischaluminat nach einem der Ansprüche 7 bis 9, dadurch gekennzeichnet, daß z für die Zahl 0 steht.

11. Mischaluminat nach einem der Ansprüche 7 bis 10, dadurch gekennzeichnet, daß v eine solche Zahl bedeutet, daß $0{,}004 \leq v \leq 0{,}2$.

12. Laser, der auf den Bereich zwischen 1380 und 1800 nm abstimmbar ist, dadurch gekennzeichnet, daß er einen Einkristall (4) eines Mischaluminats nach einem der Ansprüche 1 bis 6 umfaßt.

13. Laser, der auf den Bereich zwischen 600 und 1000 nm abstimmbar ist, dadurch gekennzeichnet, daß er einen Einkristall (4,28) eines Mischaluminats nach einem der Ansprüche 7 bis 11 umfaßt.

**Claims**

1. Mixed lanthanum – magnesium aluminate, characterized in that the aluminate is of general formula (I):
$La_{1-x}Mg_{1-y-z-t}V_{t+u}Al_{11+x+2y/3-u}O_{19-z}$ (I)
in which x represents a number such that $0<x<0.3$; y, z, t and u represent numbers such that $0< y+z+t\leq 1$ and $0<t+u\leq 1$ with $0\leq y<1$, $0<t\leq 1$ and $0\leq u<1$; and in that the aluminate is single-phase and has the structure of magnetoplumbite.

2. Mixed aluminate according to claim 1, characterized in that x is such that x is such that $0.05\leq x\leq 0.2$.

3. Mixed aluminate according to claim 1, characterized in that y, z and t are such that $0.3\leq y+z+t\leq 0.6$.

4. Mixed aluminate according to claim 1, characterized in that z is equal to 0.

5. Mixed aluminate according to claim 1, characterized in that u is equal to 0.

6. Mixed aluminate according to claim 1, characterized in that t is such that $0.02\leq t\leq 0.2$.

7. Mixed lanthanum - magnesium aluminate, characterized in that the aluminate has the following formula (II):
$La_{1-x}Mg_{1-y-z}Mt_vAl_{11+x+2y/3-v}O_{19-z}$ (II)
in which Mt represents a transition metal chosen from among titanium and zirconium; x represents a number such that $0<x<0.3$; y and z represent numbers such that $0\leq y+z\leq 1$ with $0\leq y\leq 1$ and $0\leq z\leq 1$; and v represents a number such that $0<v\leq 1$; and that the aluminate is singlephase and has the structure of the magnetoplumbite.

8. Mixed aluminate according to claim 7, characterized in that x is such that $0.05\leq x\leq 0.2$.

9. Mixed aluminate according to claims 7 or 8, characterized in that y and z are such that $0.3\leq y+z\leq 0.6$.

10. Mixed aluminate according to claims 7 or 8, characterized in that z is equal to 0.

11. Mixed aluminate according to any one of the claims 7 to 10, characterized in that v is such that $0.004\leq v\leq 0.2$.

12. Laser tunable between 1380 and 1800 nm, characterized in that it comprises a mixed aluminate monocrystal (4) according to any one of the claims 1 and 6.

13. Laser tunable between 600 and 1000 nm, characterized in that it comprises a mixed aluminate monocrystal (4, 28) according to either of the claims 7 and 11.

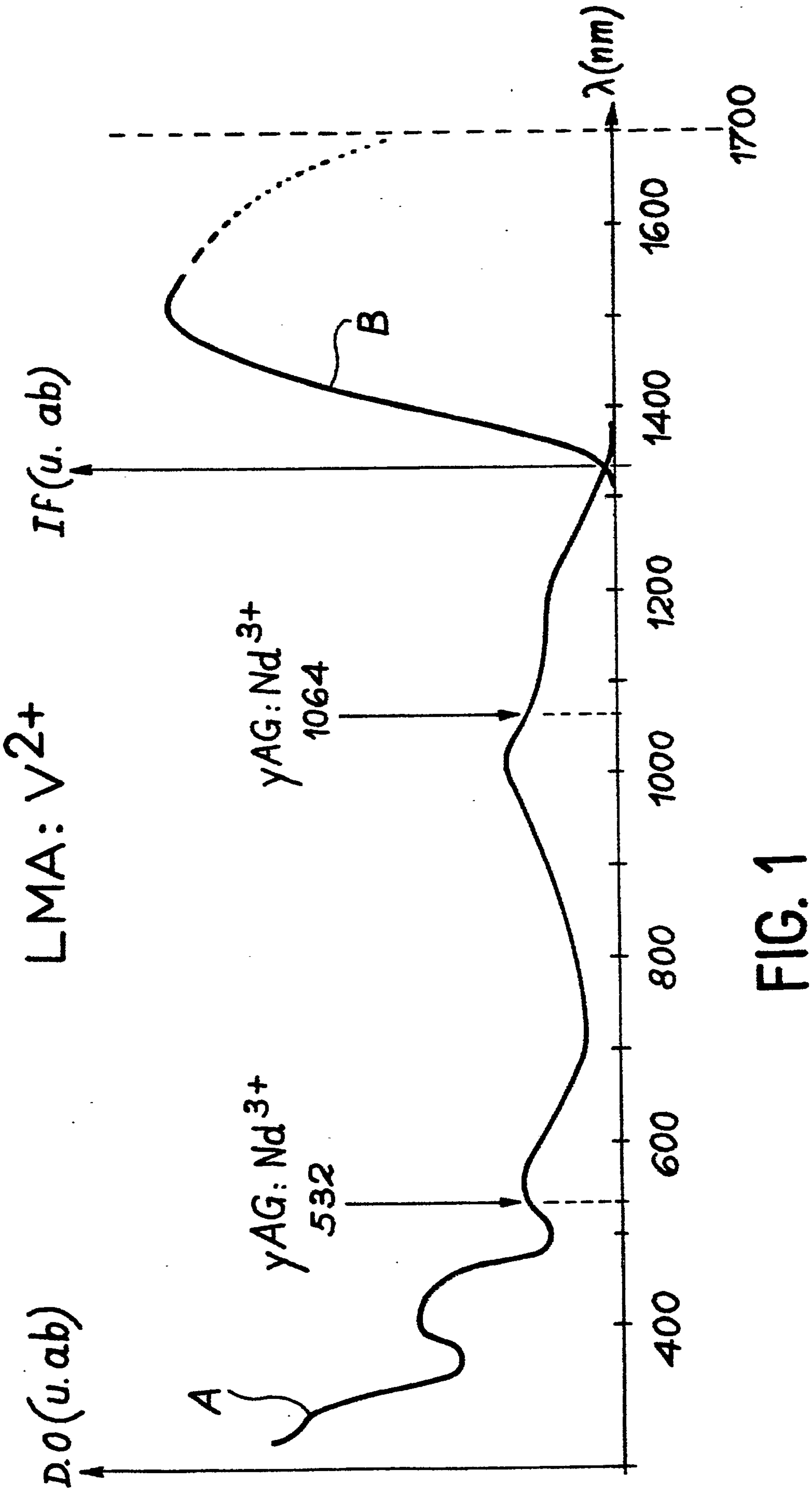
LMA: $V^{2+}$
D.O (u.ab)
If (u. ab)
λ(nm)
A
B
YAG: $Nd^{3+}$
532
YAG: $Nd^{3+}$
1064
400
600
800
1000
1200
1400
1600
1700

FIG. 1

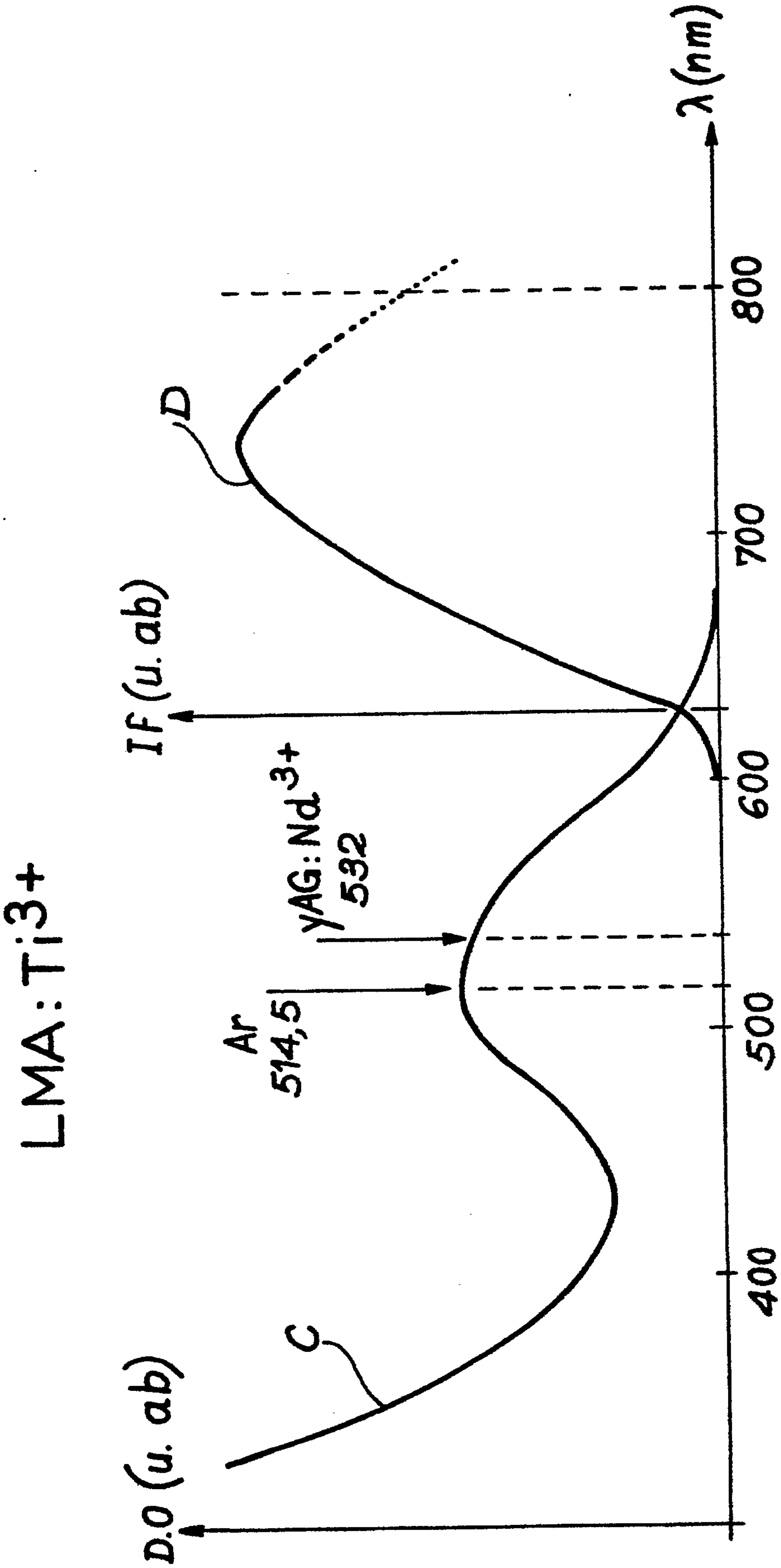
LMA : $Ti^{3+}$
D.O (u. ab)
IF (u. ab)
λ(nm)
400
500
600
700
800
C
D
Ar
514,5
YAG: $Nd^{3+}$
532

FIG. 2

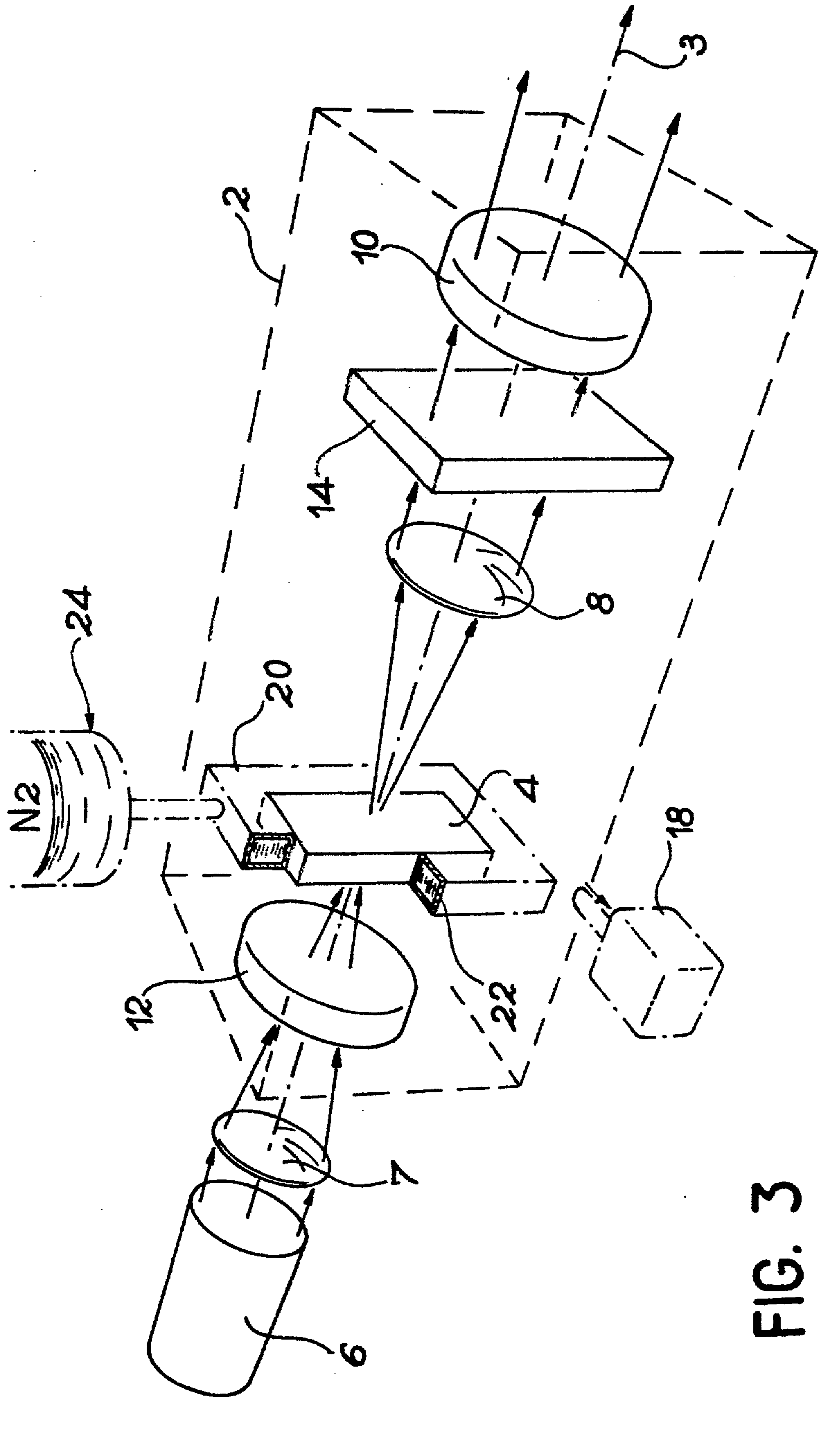


FIG. 3

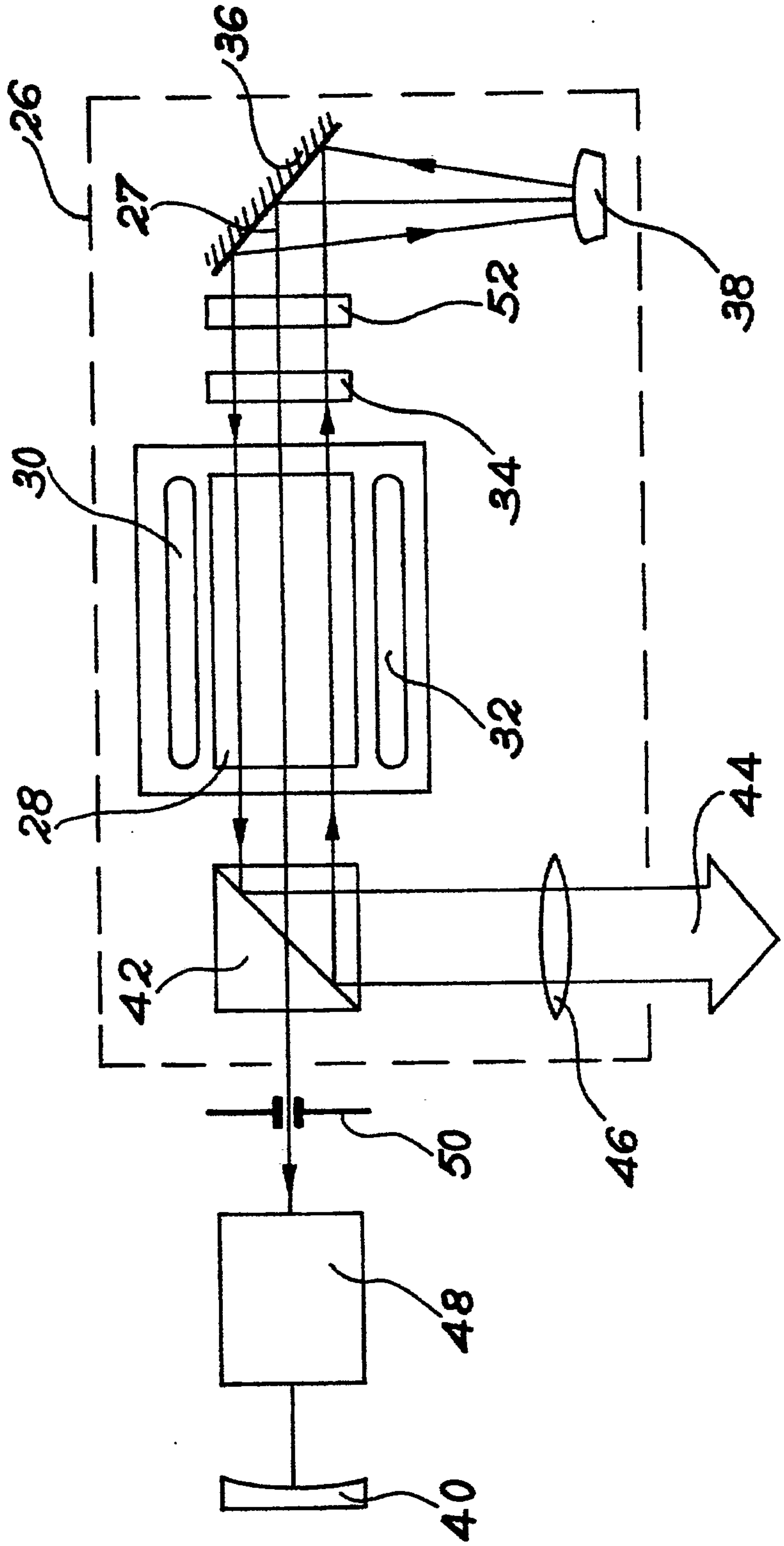


FIG. 4